# EUROPEAN PATENT APPLICATION

(11) **EP 4 553 519 A1**
(43) Date of publication of application: **14.05.2025**
(21) Application number: 23208641.3
(22) Date of filing: 08.11.2023
(51) Int. Cl.: G01R 31/382, G01R 27/02, H01M 10/42, G01R 31/396

(54) **DETECTION AND WARNING OF THERMAL RUNAWAY IN ELECTRICAL ENERGY STORAGE SYSTEMS**

(71) Applicant: VOLVO TRUCK CORPORATION, 405 08 Göteborg (SE)
(72) Inventor: ALTAF, Faisal, 421 43 VÄSTRA FRÖLUNDA (SE); VISWANATHAN, Haresh, 431 37 MÖLNDAL (SE); ANAS, Umut, 417 44 GÖTEBORG (SE)
(74) Representative: Kransell & Wennborg KB

(57) **Abstract**

A computer system (100) comprising processing circuitry (102) configured to: detect an isolation fault in an electrical energy storage system (104) comprising multiple electrical energy storage packs (106) connected in parallel to a voltage bus (108), the electrical energy storage packs each comprising a set of electrical energy storage cells (110); disconnect all but one electrical energy storage pack (106') from the voltage bus (108); determine an isolation resistance for each of the disconnected electrical energy storage packs (106), determine electrical energy storage cell temperatures for at least two cells in each of the disconnected electrical energy storage packs, provide a first thermal runaway warning signal (W1) when the isolation resistance is below a predetermined threshold, and provide a second thermal runaway warning signal (W2) when one of the electrical energy storage cell temperatures of an electrical energy storage pack exceeds a temperature threshold, and a first temperature difference between any two electrical energy storage cells of the same electrical energy storage pack exceeds a first temperature difference threshold, and provide a third thermal runaway warning signal (W3) when one of the electrical energy storage cell temperatures of an electrical energy storage pack exceeds the temperature threshold, and a second temperature difference between any two electrical energy storage cells of the same electrical energy storage pack exceeds a second temperature difference threshold.

## Description

### TECHNICAL FIELD

The disclosure relates generally to electrical energy storage systems. In particular aspects, the disclosure relates to detection and warning of thermal hazards in electrical energy storage systems. The disclosure can be applied to heavy-duty vehicles, such as trucks, buses, and construction equipment. The disclosure can further be applied to marine vessels and passenger cars among other vehicle types. The disclosure may also be applied to stationary applications. Although the disclosure may be described with respect to a particular vehicle, the disclosure is not restricted to any particular vehicle.

### BACKGROUND

Electrical energy storages may include multiple electrical energy storage packs which may store large amounts of energy. Faults that cause thermal runaway events may lead to hazardous events such a fire. For increased safety, it is therefore important to monitor the condition of the electrical energy storage packs and provide suitable warnings in the event of detected potentially risky conditions of the electrical energy storage packs.

### SUMMARY

According to a first aspect of the disclosure, there is provided a computer system comprising processing circuitry configured to: detect an isolation fault in an electrical energy storage system comprising multiple electrical energy storage packs connected in parallel to a voltage bus, the electrical energy storage packs each comprising a set of electrical energy storage cells; disconnect all but one electrical energy storage pack from the voltage bus; determine an isolation resistance for each of the disconnected electrical energy storage packs, determine electrical energy storage cell temperatures for at least two cells in each of the disconnected electrical energy storage packs, provide a first thermal runaway warning signal when the isolation resistance is below a predetermined threshold, and provide a second thermal runaway warning signal when one of the electrical energy storage cell temperatures of an electrical energy storage pack exceeds a temperature threshold, and a first temperature difference between any two electrical energy storage cells of the same electrical energy storage pack exceeds a first temperature difference threshold, and provide a third thermal runaway warning signal when one of the electrical energy storage cell temperatures of an electrical energy storage pack exceeds the temperature threshold, and a second temperature difference between any two electrical energy storage cells of the same electrical energy storage pack exceeds a second temperature difference threshold.

The first aspect of the disclosure may seek to improve thermal runaway detection and provide multiple redundant warning triggers for a potential detected thermal runaway event. A technical benefit may include to provide an early thermal runaway trigger signal before the thermal runaway event leads to a hazardous situation.

Furthermore, maintaining one electrical energy storage pack connected to the voltage bus advantageously allows for the still operational electrical energy storage pack to provide energy to the voltage bus to bring a vehicle or a load to a safe stop.

The first and second cell temperature differences are calculated, or provided, in two different ways, providing for advantages redundancy in case one of the ways fails, for example due to data corruption or other communication issues or failures. The first and second cell temperature differences may be equal and based on the same cell temperature measurements. However, the first and second cell temperature differences may be calculated by two different units or processing circuitries.

Optionally in some examples, including in at least one preferred example, the processing circuitry may be further configured to: provide the first thermal runaway warning signal when a measured isolation resistance of a single pole of an electrical energy storage pack is below a single pole resistance threshold or if a measured isolation resistance of two poles of an electrical energy storage pack is below a two-pole resistance threshold. A technical benefit may include that a first early warning trigger may be provided that is directly based on the isolation resistance of the electrical energy storage pack which may for example be an indication of a coolant leakage or water ingress or high humidity in the electrical energy storage pack.

Optionally in some examples, including in at least one preferred example, the two-pole resistance threshold may be higher than the single pole resistance threshold. A technical benefit may include that the thresholds are tailored and therefore more accurate for performing isolation resistance evaluations. The threshold may be calibrated and re-calibrated depending on circumstances and conditions of the electrical energy storage packs. Furthermore, double isolation faults are more severe whereby it is advantageous to provide the warning signal at relatively higher isolation resistances than for single pole isolation faults.

Optionally in some examples, including in at least one preferred example, the processing circuitry may be further configured to: provide the second thermal runaway warning signal only when the temperature difference between the two electrical energy storage cells of the same electrical energy storage pack is equal to or exceeds the first temperature difference threshold for a time duration that exceeds or is equal to a predetermined time duration threshold. In other words, the temperature difference between the two electrical energy storage cells should remain above or equal to the first temperature difference for a time duration that is longer than or equal to the predetermined time duration threshold. A technical benefit may include to more accurately determine that a thermal runaway may be on the way and thereby provide an early warning signal thereof.

Optionally in some examples, including in at least one preferred example, the first temperature difference threshold may be lower than the second temperature difference threshold. A technical benefit may include that two separate triggers for different temperature differences may be provided to increase the redundancy of the warning triggers.

Optionally in some examples, including in at least one preferred example, the processing circuitry may be further configured to: in response to any of the warning signals, provide an output message to a user interface.

Optionally in some examples, including in at least one preferred example, determine which one of the electrical energy storage packs has the highest isolation resistance, wherein the one electrical energy storage pack remains connected to the voltage bus. That is, the one electrical energy storage pack that is not disconnected from the voltage bus is the electrical energy storage packs with the highest isolation resistance. A technical benefit may include improved safety since the safest electrical energy storage pack with least risk of being faulty, remains connected to the voltage bus to provide energy to the load.

Optionally in some examples, including in at least one preferred example, the first temperature difference threshold may be selected from the range of 5-30°C and the second temperature difference threshold may be at about 20°C.

Optionally in some examples, including in at least one preferred example, the processing circuitry may be further configured to: calculate the first temperature difference based on cell temperature measurements from two electrical energy storage cells of each electrical energy storage pack, and receive, over a communication interface, an indication that the second temperature difference exceeds or is equal to the second temperature difference threshold from a pack management unit of the respective electrical energy storage pack. A technical benefit may include improved redundancy in calculating the temperature differences that are used for triggering the second and third warning signals.

There is further provided an electric energy storage system comprising the computer system of the first aspect.

There is further provided a vehicle comprising the electrical energy storage system.

According to a second aspect of the disclosure, there is provided a computer-implemented method, comprising: detecting, by processing circuitry of a computer system, an isolation fault in an electrical energy storage system comprising multiple electrical energy storage packs connected in parallel to a voltage bus, the electrical energy storage packs each comprising a set of electrical energy storage cells; disconnecting, by the processing circuitry, all but one electrical energy storage pack from the voltage bus; determining, by the processing circuitry, an isolation resistance for each of the disconnected electrical energy storage packs, determining, by the processing circuitry, electrical energy storage cell temperatures for at least two cells in each of the disconnected electrical energy storage packs, providing, by the processing circuitry, a first thermal runaway warning signal when the isolation resistance is below a predetermined threshold, and providing, by the processing circuitry, a second thermal runaway warning signal when one of the electrical energy storage cell temperatures of an electrical energy storage pack exceeds a temperature threshold, and a temperature difference between any two electrical energy storage cells of the same electrical energy storage pack exceeds a first temperature difference threshold, and providing, by the processing circuitry, a third thermal runaway warning signal when one of the electrical energy storage cell temperatures of an electrical energy storage pack exceeds the temperature threshold, and a temperature difference between any two electrical energy storage cells of the same electrical energy storage pack exceeds a second temperature difference threshold.

The second aspect of the disclosure may seek to improve thermal runaway detection and provide multiple redundant warning triggers for a detected thermal runaway event. A technical benefit may include to provide an early thermal runaway trigger signal before the thermal runaway event leads to a hazardous situation.

Optionally in some examples, including in at least one preferred example, the method may comprise: providing by the processing circuitry, the first thermal runaway warning signal when a measured isolation resistance of a single pole of an electrical energy storage pack is below a single pole resistance threshold or if a measured isolation resistance of two poles of an electrical energy storage pack is below a two-pole resistance threshold. A technical benefit may include that a first early warning trigger may be provided that is directly based on the isolation resistance of the electrical energy storage pack which may for example be an indication of a coolant leakage or water ingress or high humidity in the electrical energy storage pack.

Optionally in some examples, including in at least one preferred example, the two-pole resistance threshold may be higher than the single pole resistance threshold. A technical benefit may include that the thresholds are tailored and therefore more accurate for performing isolation resistance evaluations. The threshold may be calibrated and re-calibrated.

Optionally in some examples, including in at least one preferred example, the method may comprise: providing, by the processing circuitry, the second thermal runaway warning signal only when the temperature difference between the two electrical energy storage cells is equal to or exceeds the first temperature difference threshold for a time duration that exceeds or is equal to a predetermined time duration threshold. A technical benefit may include to more accurately determine that a thermal runaway may be on the way and thereby provide an early warning signal thereof.

Optionally in some examples, including in at least one preferred example, the first temperature difference threshold may be lower than the second temperature difference threshold. A technical benefit may include that two separately triggers for different temperature differences may be provided to increase the redundancy of the warning triggers.

Optionally in some examples, including in at least one preferred example, the method may comprise: in response to any of the warning signals, providing, by the processing circuitry, an output message to a user interface. A technical benefit may include improved safety and that operational electrical energy storage packs may still provide energy to the voltage bus to bring a load to a stop.

Optionally in some examples, including in at least one preferred example, the method may comprise: determining which one of the electrical energy storage packs has the highest isolation resistance, wherein the one electrical energy storage pack remains connected to the voltage bus. A technical benefit may include improved safety since the safest electrical energy storage pack with least risk of being faulty, remains connected to the voltage bus to provide energy to the load.

Optionally in some examples, including in at least one preferred example, the method may comprise: calculating, by the processing circuitry, the first temperature difference based on cell temperature measurements from two cells of each electrical energy storage pack, and receive, by the processing circuitry over a communication interface, an indication that the second temperature difference exceeds or is equal to the second temperature difference threshold from a pack management unit of the respective electrical energy storage pack. A technical benefit is that if the fault signal or code that flags large temperature difference between cells in a same electrical energy storage pack for triggering the third warning signal gets corrupted during calculation or communication then redundancy is provided by also calculating the temperature difference locally by the computer system of the electrical energy storage system inside based on min and max temperature measurements. A more reliable warning system is provided in this way compared to relying on the Fault Code regarding large temperature difference communicated by the management unit of the electrical energy storage packs.

Optionally in some examples, including in at least one preferred example, the temperature threshold may be in the range of 40°C to 55°C.

There is further provided a computer program product comprising program code for performing, when executed by the processing circuitry, the method of the second aspect.

There is further provided a non-transitory computer-readable storage medium comprising instructions, which when executed by the processing circuitry, cause the processing circuitry to perform the method of any of the second aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of a computer system according to an example.
**FIG. 2** is an exemplary system diagram of a computer system according to an example.
**FIG. 3** is a flow chart of an exemplary method.
**FIG. 4** is a logic scheme over thermal runaway warning signals according to an example.
**FIG. 5** is an exemplary vehicle according to an example.
**FIG. 6** is another view of **FIG. 1****,** according to an example.
**FIG. 7** is a flow chart of an exemplary method according to an example.
**FIG. 8** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Isolation resistance faults in electrical energy storage systems may lead to short circuit and subsequently to thermal runaway, which is an uncontrolled heat development in the electrical energy storage system and may lead to hazardous situations such as fire. Potential sources of isolation resistance fault may be coolant leakage, water ingress, or high humidity in the electrical energy storage system which may lead to short circuits. A challenge is to identify the location of the isolation fault, especially in parallel connected multi pack electrical energy storage systems during vehicle operation. It is therefore important to as soon as possible provide a warning to an operator of a potential thermal runaway.

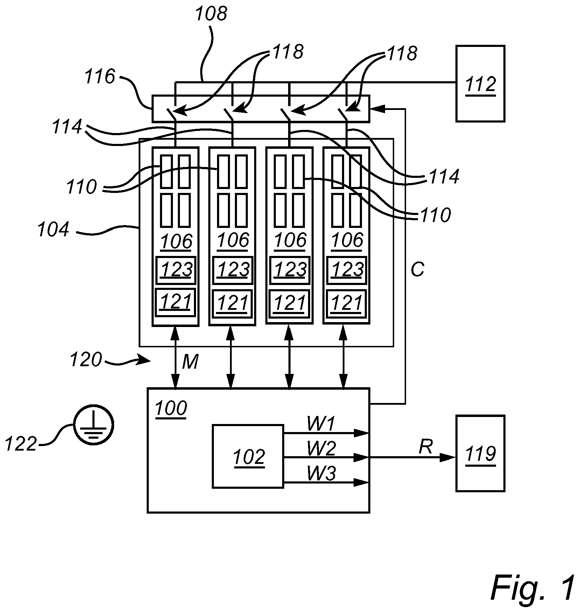

**FIG. 1** is an exemplary system diagram of a computer system 100 comprising processing circuitry 102 according to an example.

The processing circuitry 102 is electrically connected for control and communication with an electrical energy storage system 104 comprising multiple parallel connected electrical energy storage packs 106. The electrical energy storage packs 106 each comprises a set of electrical energy storage cells 110 that are electrically connected to provide an energy output. The electrical energy storage packs 106 are electrically connected in parallel to a voltage bus 108 for providing power to an electric load 112. The cells 110 may be Li-ion cells.

Energy output ports 114 of the electrical energy storage packs 106 are connected to a switching circuitry 116 comprising one switch 118 for each electrical energy storage pack 106. The switches 118 which may be provided as contactors are individually controllable by the processing circuitry 102 which may control the state of the switches 118 by sending control messages C to the switching circuitry 116. The state of the switches 118 are an open state in which the respective electrical energy storage pack 106 is not connected to the voltage bus 108 and a closed state in which the respective electrical energy storage pack 106 is connected to the voltage bus 108 and can provide energy to the electrical load 112 via the voltage bus 108. The electrical energy storage packs are connected in parallel to the voltage bus 108 via the switches 118.

The processing circuitry 108 is further connected to a user interface 119 to which the processing circuitry 108 may provide control message R which may include warning signals W1, W2, W3, as described herein. The user interface 119 may provide at least one of audio, visual, and textual warning indications to an operator.

The processing circuitry 108 is connected to the electrical energy storage packs 104 by an electrical connection interface 120 which provides for the processing circuitry 108 to receive measurement data from sensors 121 that measure for example cell/pack voltage, electrical current, temperature, and isolation measurements such as impedance or resistance from at least one pole of any one of the electrical energy storage packs 106 to ground 122 such as the chassis of a vehicle 100 or a chassis of the electrical energy storage system. This provides for the processing circuitry 108 to perform isolation fault check of electrical energy storage packs 104 when they are disconnected from the voltage bus 108. Performing isolation fault check is typically done by measuring the resistance from the electrical energy storage pack 106 to ground 122. A low resistance may be an indication of an isolation fault and high isolation resistance is desired to avoid electrical shock. Typically, a desirable isolation resistance is in the range of mega-ohms in a normal electrical energy storage pack. But in a faulty electrical energy storage pack, the value may drop to a low value, which means that there is a risk of short-circuit between a pole of the electrical energy storage pack and a casing of the pack or electrical energy storage system. If both poles have low isolation resistance, then there is a risk that poles get short-circuited via low resistance path through casing.

After an electrical energy storage pack 106 is disconnected from the other electrical energy storage packs 106, the isolation resistance for each disconnected electrical energy storage pack is measured between each pole of the electrical energy storage pack and the electrical energy storage chassis. Two isolation resistance values are obtained, i.e., positive pole isolation resistance and a negative pole isolation resistance.

Isolation resistance is measured using a switched electrical circuit that is controlled through software components. Isolation resistance monitoring is a standard functionality inside high voltage electrical energy storage packs today and are *per se* known to the skilled person and will not be discussed in detail herein.

Furthermore, temperature sensors provide for measuring the temperature of individual cells 110 of the electrical energy storage packs 106.

Each electrical energy storage pack 106 comprises pack management processing circuitry 123 which is configured to monitor the respective electrical energy storage pack 106 based on measurements from the sensors 121. The pack management processing circuitry 123 has access to all the sensor data measured by the sensors 121. However, only part of the measurements performed by the sensors 121 are transmitted to the processing circuitry 102 external to the electrical energy storage packs 106. In other words, the pack management processing circuitry 123 has access to more data than the external processing circuitry 102.

The processing circuitry 102 receives, over the communication interface 120, cell temperature measurements from the sensors 121. However, not all sensing data is transmitted to the processing circuitry 102, but at least two cell measurements from each electrical energy storage pack 106 is transmitted to the processing circuitry 102 from each electrical energy storage pack 106. Preferably, the pack management processing circuitry 123 transmits the maximum cell temperature and the minimum cell temperature of the respective electrical energy storage pack 106. Based on the cell temperature measurements for only a subset of cells (maximum and minimum cell temperature), the processing circuitry 102 is configured to determine the first temperature difference between two electrical energy storage cells 110 of the same electrical energy storage pack 106. Thus, the first temperature difference may be the difference between the maximum cell temperature and the minimum cell temperature of the respective electrical energy storage pack 106. It is envisaged that the processing circuitry 102 receives cell temperature measurements only for the maximum cell temperature and the minimum cell temperature of the respective electrical energy storage pack 106.

The pack management processing circuitry 123 which has access to all the cell temperature measurements calculates the second temperature difference between the cells 110 of the respective electrical energy storage pack 106. The processing circuitry 102 is configured to receive a control message *M* from the pack management units 123 over the communication interface 120, that indicates whether or not the second temperature difference between any two electrical energy storage cells of the same electrical energy storage pack 106 exceeds a second temperature difference threshold. In other words, the first temperature difference is calculated by the processing circuitry 102 based on the limited cell measurement data, i.e., the maximum cell temperature and the minimum cell temperature of the respective pack 106, whereas the second temperature difference is calculated by the pack management units 123 based on all the cell temperature measurements of the respective electrical energy storage pack 106.

Note here that the first temperature difference and the second temperature difference may be measured by the same sensors 121, but the evaluation in view of the respective temperature difference threshold is performed in two different locations.

The communication interface 120 may be CAN-bus. It is envisaged that a single CAN-bus is shared between the electrical energy storage packs 106 for communication with the computer system 100. It is also envisaged to have separate CAN-buses for each electrical energy storage pack 106.

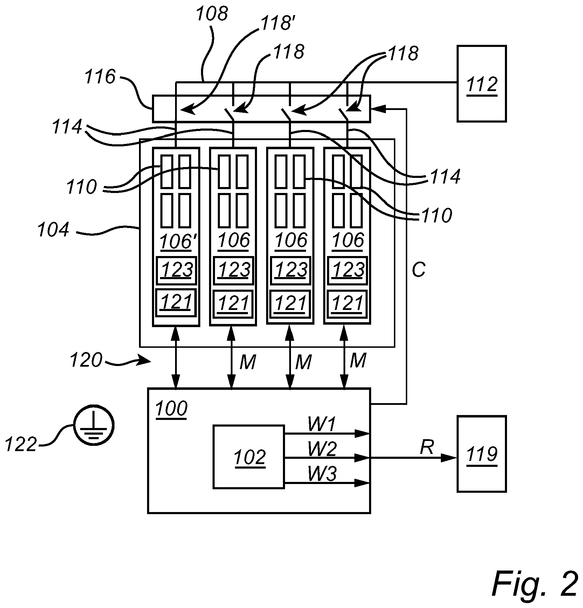

Turning to **FIG. 2****,** the processing circuitry 102 controls, in one example, the switching circuitry 116 to disconnect all but one electrical energy storage pack 106' from the voltage bus 108. In other words, all the switches 118 are opened except for the switch 118' which remains closed so that the electrical energy storage pack 106' remains connected to the voltage bus 108 to provide energy to the electric load 112.

Which electrical energy storage pack to remain connected to the voltage bus 108 may be determined by firstly determining which one of the electrical energy storage packs 106 had an isolation resistance greater than a certain threshold the last time isolation resistance was measured, wherein the one electrical energy storage pack 106' remains connected to the voltage bus 108. In other words, the isolation resistance is based on historical isolation resistance data reported to the computer system of the electrical energy storage system from each pack 106 before last connection of the electrical energy storage pack. If multiple electrical energy storage packs 106 had isolation resistance above a certain threshold, then the electrical energy storage pack with the highest state of charge, SoC, is remains connected to the voltage bus. At the same time, the processing circuitry 102 may check that the candidate electrical energy storage pack is not reporting any fault, such as e.g., temperature difference between cells over a certain threshold or max cell temperature above a certain threshold. That is, preferably, the selected electrical energy storage pack may have highest SoC, have high enough isolation resistance based on last reported value, and have no other faults.

In other words, the one electrical energy storage pack 106' which is best isolated and therefore is less likely to be subject to thermal runaway, and preferably with highest SoC, is allowed to remain connected to the bus 108 so that operation of the electric load 112 can continue, for example to manage the electric load 112 to a safe stop.

The processing circuitry 102 determines an isolation resistance for each of the disconnected electrical energy storage packs 106. That is, the processing circuitry 102 receives measurement data from sensors 121, or from the pack management units 123, via the interface 120 so that the isolation resistances can be determined.

Furthermore, the processing circuitry 102 determines electrical energy storage cell 110 temperatures for at least two cells 100 in each of the disconnected electrical energy storage packs 106. Again, the processing circuitry 102 receives measurement data from sensors 121, or from the pack management units 123, via the interface 120 so that the cell temperatures can be determined.

The processing circuitry 102 evaluates the isolation resistance and the cell temperatures and may provide three different thermal runaway warning signals.

The processing circuitry 102 provides a first thermal runaway warning signal, W1, when the isolation resistance for any one of the disconnected electrical energy storage packs 106 is below a predetermined threshold. The isolation resistance may be measured for a single pole of an electrical energy storage pack 106 and be compared to a single pole resistance threshold. The isolation resistance may be measured for two poles of an electrical energy storage pack 106 and be compared to a two-pole resistance threshold.

The first thermal runaway warning signal W1 may be provided when a measured isolation resistance of the single pole of an electrical energy storage pack 106 is below the single pole resistance threshold or if a measured isolation resistance of the two poles of an electrical energy storage pack 106 is below the two-pole resistance threshold. In case of the two-pole resistance, a measured isolation resistance of both the poles, i.e., a negative and a positive pole should be below the two-pole resistance for the first thermal runaway warning signal W1 to be provided.

Monitoring both single pole and two-pole isolation resistance provide for a two-layer trigger for providing the first warning signal W1. Preferably, the two-pole resistance threshold is higher than the single pole resistance threshold. For example, the two-pole resistance threshold may be at least twice the single pole resistance threshold. For example, the two-pole resistance threshold may be three times, or four times, or five times, or even six times the single pole resistance threshold.

As an example, the single pole resistance threshold may be 3 kΩ. As a further example, the two-pole resistance threshold may be 25 kΩ.

One advantage of setting the single pole resistance threshold higher than the two-pole resistance threshold is that double isolation faults are more hazardous than single pole isolation faults since it increases the risk of short circuit between positive and negatives poles of the electrical energy storage pack. Therefore, it is beneficial to provide the first warning signal warning at relatively higher two-pole resistance threshold (e.g., <25 kOhm) for early hazardous warning. On the other hand, in case of single pole isolation fault, a relatively less hazardous situation occurs since a short-circuit will not occur until both poles have low isolation resistance (i.e., double isolation fault). Advantageously, the first warning signal is provided in case of single isolation fault, but to avoid too many "false alarms", it is required that, under single pole isolation fault, the isolation resistance from that pole to e.g., the chassis must be relatively lower i.e., lower than a certain lower single pole threshold (e.g., < 3 kOhm). Furthermore, a single pole isolation fault with too low isolation resistance value may also indicate that there is a relatively high likelihood of developing double isolation fault soon, so it is advantageous to act in time instead of waiting for a two-pole isolation fault to occur.

The processing circuitry 102 provides a second thermal runaway warning signal W2 when one of the electrical energy storage cell temperatures of a disconnected electrical energy storage pack 106 exceeds a temperature threshold, and a first temperature difference between any two electrical energy storage cells of the same electrical energy storage pack 106 exceeds a first temperature difference threshold. In other words, for the second thermal runaway warning signal W2 to be issued, it is required that the temperature of one of the cells 110 of a disconnected electrical energy storage pack 106 exceeds a predetermined temperature threshold and that a thermal imbalance between any two cells 110 of the same disconnected electrical energy storage pack 106 exceeds a first temperature difference threshold. The first temperature difference is preferably determined by the processing circuitry 102 based on the minimum cell temperature and maximum cell temperature for each electrical energy pack.

It may be required that the electrical energy storage cell temperatures of a disconnected electrical energy storage pack 106 exceeds the temperature threshold for at least a predetermined time duration of a few seconds. This may be considered a first predetermined time duration.

The first temperature difference threshold is calibratable and may be adjusted based on circumstances such as electrical energy storage system configuration, electric load 112, electrical energy storage system usage level such as average power output levels, etc. Furthermore, the predetermined temperature threshold is also calibratable.

A calibration of the first temperature difference threshold and/or the predetermined temperature threshold may further depend on cell chemistry. In addition, the calibration may also be affected by the thermal management for the electrical energy storage packs. For example, a higher threshold may be required for electrical energy storage packs where the thermal management system design naturally lead to larger thermal imbalance, whereas in electrical energy storage packs with optimal thermal management system, the threshold may be lower. Also, the temperature thresholds may depend on the impact of ambient differences on cell thermal imbalance.

The first temperature difference threshold and the second temperature difference threshold are calibrated at two different instances of the system. The first temperature difference threshold is calibrated for use in the processing circuitry whereas the second temperature difference threshold is calibrated for the pack management unit 123. Two different calibrations advantageously provide flexibility in how to adapt reactivity to different vehicle applications and different situations. The possibility to calibrate/adapt the first temperature difference threshold in any control unit outside the electrical energy storage packs gives freedom and possibility to over-ride the pack management unit threshold according to given vehicle application and situation or other application.

In some possible examples, the second thermal runaway warning signal W2 is only provided when the temperature difference between the two electrical energy storage cells 110 is equal to or exceeds the first temperature difference threshold for a time duration that exceeds or is equal to a second predetermined time duration threshold. In other words, it may not be sufficient that the first temperature difference threshold is exceeded only for a very brief moment. Instead, it may be required that the thermal imbalance remains over or equal to for at least a second predetermined time duration. The predetermined time duration may be for example 2 seconds, 5 seconds, 10 seconds, and may be calibratable.

The processing circuitry 102 provides a third thermal runaway warning signal, W3, when one of the electrical energy storage cell 110 temperatures of an electrical energy storage pack 106 exceeds the temperature threshold, and a temperature difference between any two electrical energy storage cells 110 of the same electrical energy storage pack 106 exceeds a second temperature difference threshold. In other words, as a further layer of redundancy, a second temperature difference threshold is introduced. Preferably, the first temperature difference threshold is lower than the second temperature difference threshold. The second temperature difference is preferably determined by a pack management unit 123 of the respective electrical energy storage pack. The processing circuitry 102 receives a message M that indicates when the second temperature difference has been violated.

The second temperature difference threshold is typically pre-calibrated and thus "fixed" and provided by pack management units of the electrical energy storage system 104. In contrast, the first temperature difference threshold may be re-calibrated by the processing circuitry 102.

As an example, the first temperature difference threshold may be calibratable in the range of 7-30°C and the second temperature difference threshold may be calibrated at about 20°C.

The processing circuitry 102 is further configured to provide an output R to a user interface indicative of the warning signals W1, W2, W3.

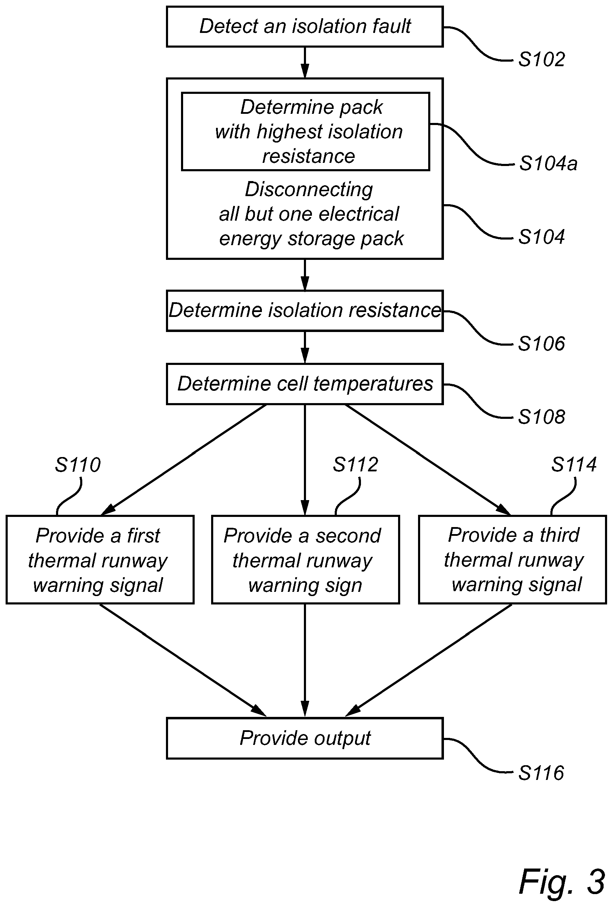

**FIG. 3** is a flow-chart of method steps according to an example method.

In step S102, detecting, by processing circuitry 102 of a computer system 100, an isolation fault in an electrical energy storage system 104 comprising multiple electrical energy storage packs 106 connected in parallel to a voltage bus 108, the electrical energy storage packs each comprising a set of electrical energy storage cells 110.

In step S104, disconnecting, by the processing circuitry 102, all but one electrical energy storage pack 106' from the voltage bus 108. Optionally, in prior step S104a, determining which one of the electrical energy storage packs has the highest isolation resistance last time the time isolation resistance was measured, wherein the one electrical energy storage pack 106' remains connected to the voltage bus. Furthermore, determining which one of the electrical energy storage packs to remain connected to the voltage bus 108 may include determining the state of charge of the electrical energy storage packs that have equal or similar isolation resistances, wherein the electrical energy storage pack with the highest State-of-Charge, SoC, remains connected to the voltage bus 108. Further, it may also be a requirement that the electrical energy storage pack that remains connected to the voltage bus does not have any other faults. In other words, the electrical energy storage pack that is selected to remain connected to the voltage bus 108 may have highest SoC, have high enough isolation resistance, according to a threshold, based on last reported value, and have no other faults.

In step S106, determining, by the processing circuitry 102, an isolation resistance for each of the disconnected electrical energy storage packs 106.

In step S108 determining, by the processing circuitry 102, electrical energy storage cell 110 temperatures for at least two cells 110 in each of the disconnected electrical energy storage packs 106.

Next, three different warning signals are provided based on different underlying parameters and thresholds.

A first thermal runaway warning signal W1 is provided by the processing circuitry 102 in step S 110, when the isolation resistance is below a predetermined threshold. The first thermal runaway warning signal maybe provided when a measured isolation resistance of a single pole of an electrical energy storage pack 106 is below a single pole resistance threshold or if a measured isolation resistance of two poles of an electrical energy storage pack 106 is below a two-pole resistance threshold.

A second thermal runaway warning signal W2 is provided in step S112, by the processing circuitry 102, when one of the electrical energy storage cell temperatures of an electrical energy storage pack 106 exceeds a temperature threshold, and a first temperature difference between any two electrical energy storage cells 110 of the same electrical energy storage pack 106 exceeds a first temperature difference threshold. The second thermal runaway warning signal may be provided only when the first temperature difference between the two electrical energy storage cells is equal to or exceeds the first temperature difference threshold for a time duration that exceeds or is equal to a predetermined time duration threshold.

A third thermal runaway warning signal W3 is provided in step S 114, by the processing circuitry 102, when one of the electrical energy storage cell 110 temperatures of an electrical energy storage pack 106 exceeds the temperature threshold, and a second temperature difference between any two electrical energy storage cells 110 of the same electrical energy storage pack 106 exceeds a second temperature difference threshold.

In response to any of the warning signals, providing, by the processing circuitry, an output message R to a user interface 119 in step S116.

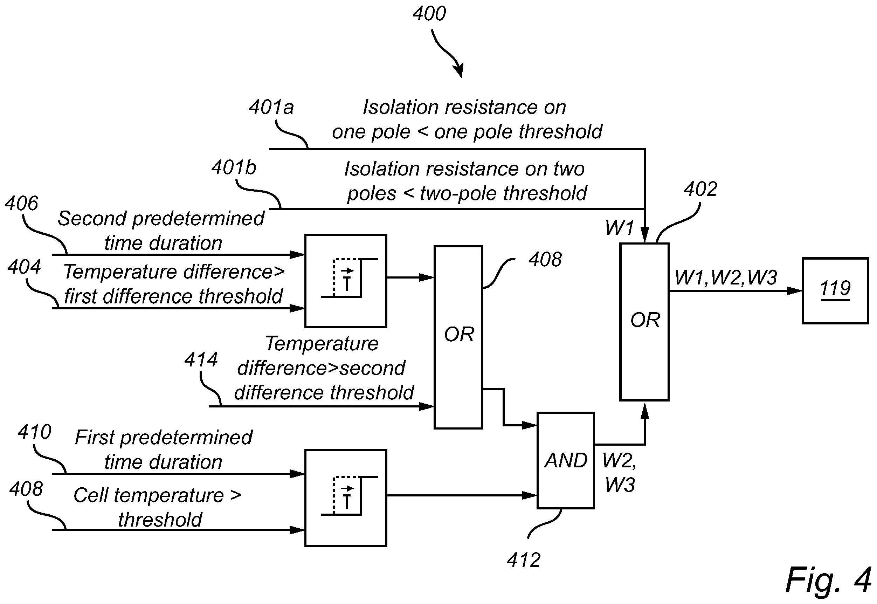

**FIG. 4** is a logic scheme 400 for the first, second, and third warning signals.

Firstly, if the isolation resistance on one pole of a disconnected electrical energy storage pack is below the one pole threshold 401a, or if the isolation resistance on two poles of a disconnected electrical energy storage pack is below the two-pole threshold, then the output of the OR-gate 402 is a logic 1 and that warning signal W1 is provided to the user interface 119.

Advantageously, if the isolation resistances of both poles, negative and positive, are below the two-pole resistance threshold (e.g., 25 k Ohm) then the fault is considered a "hazardous double isolation fault", or, if only one of pole's isolation resistance is below the one pole threshold, then then the fault is considered a "hazardous single isolation fault".

Turning to the second warning signal W2. If the first temperature difference 404, or thermal imbalance, between two cells of a disconnected electrical energy storage pack exceeds the first temperature different threshold, which may be lower than the second temperature difference threshold, and this thermal imbalance is maintained for a time duration that exceeds or is equal to the second predetermined time duration 406, such as five seconds, then a logic 1 is output from the OR-gate 408. If, at the same time the cell temperature of a cell in the same electrical energy storage pack exceeds or is equal to the temperature threshold 408, such as 45°C for at least a first predetermined time duration 410, such as five seconds, AND-gate 412 provides a logic 1 that in this case triggers the second warning signal W2. The first temperature difference is preferably determined by the processing circuitry based on the minimum cell temperature and maximum cell temperature for each electrical energy pack.

If the second temperature difference 414, or thermal imbalance, between two cells of a disconnected electrical energy storage pack exceeds the second temperature difference threshold, which may be higher than the first temperature different threshold, then a logic 1 is output from the OR-gate 408. If, at the same time the cell temperature of a cell in the same electrical energy storage pack exceeds or is equal to the temperature threshold 408 for at least a first predetermined time duration 410, AND-gate 412 provides a logic 1 that in this case triggers the third warning signal W3. The second temperature difference may be calculated locally in each electrical energy storage pack 106.

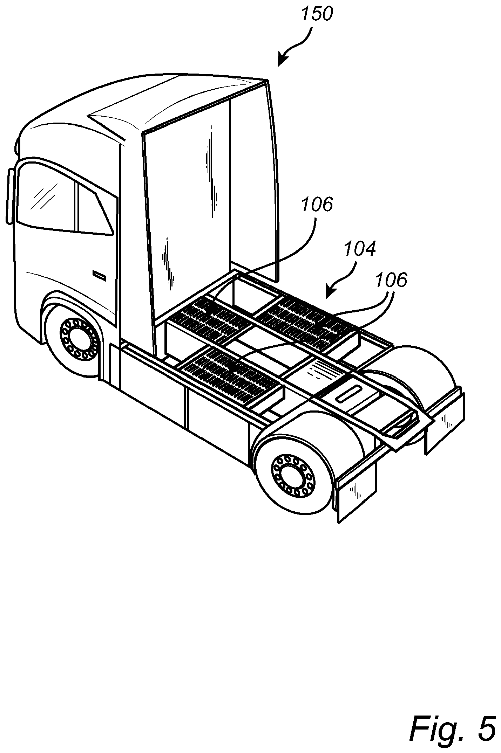

**FIG. 5** is an example vehicle 150 according to embodiments of the present disclosure. The vehicle 150 is here shown as a heavy-duty truck but other types of vehicles are also applicable. The vehicle 150 comprises a hybrid-, or fully electric driveline that is powered by an electrical energy storage system 104 comprising multiple parallel connected electrical energy storage packs 106. The electrical energy storage packs 104 comprises a plurality of electrical energy storage cells.

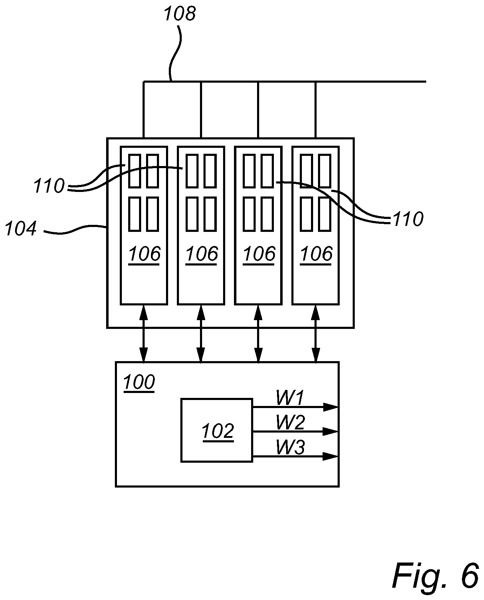

**FIG. 6** is another view of **FIG. 1****,** according to an example.

**FIG. 6** illustrates a computer system 100 comprising processing circuitry 102 configured to: detect an isolation fault in an electrical energy storage system 104 comprising multiple electrical energy storage packs 106 connected in parallel to a voltage bus 108, the electrical energy storage packs 106 each comprising a set of electrical energy storage cells 110; disconnect all but one electrical energy storage pack from the voltage bus 108; determine an isolation resistance for each of the disconnected electrical energy storage packs 106, determine electrical energy storage cell 110 temperatures for at least two cells 110 in each of the disconnected electrical energy storage packs 106, provide a first thermal runaway warning signal W1 when the isolation resistance is below a predetermined threshold, and provide a second thermal runaway warning signal W2 when one of the electrical energy storage cell 110 temperatures of an electrical energy storage pack exceeds a temperature threshold, and a temperature difference between any two electrical energy storage cells 110 of the same electrical energy storage pack 106 exceeds a first temperature difference threshold, and provide a third thermal runaway warning signal W3 when one of the electrical energy storage cell 110 temperatures of an electrical energy storage pack 106 exceeds the temperature threshold, and a temperature difference between any two electrical energy storage cells 110 of the same electrical energy storage pack 106 exceeds a second temperature difference threshold.

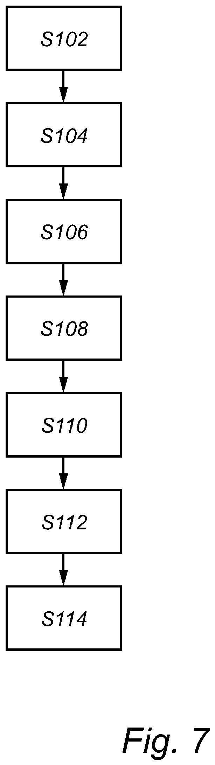

**FIG. 7** is a flow chart of a method according to an example. In step S102 detecting, by processing circuitry of a computer system, an isolation fault in an electrical energy storage system comprising multiple electrical energy storage packs connected in parallel to a voltage bus, the electrical energy storage packs each comprising a set of electrical energy storage cells. In step S104, disconnecting, by the processing circuitry, all but one electrical energy storage pack from the voltage bus. In step S106 determining, by the processing circuitry, an isolation resistance for each of the disconnected electrical energy storage packs. In step S108, determining by the processing circuitry, electrical energy storage cell temperatures for at least two cells in each of the disconnected electrical energy storage packs. In step S 110 providing, by the processing circuitry, a first thermal runaway warning signal when the isolation resistance is below a predetermined threshold. In step S112, providing, by the processing circuitry, a second thermal runaway warning signal when one of the electrical energy storage cell temperatures of an electrical energy storage pack exceeds a temperature threshold, and a first temperature difference between any two electrical energy storage cells of the same electrical energy storage pack exceeds a first temperature difference threshold. In step S 114, providing, by the processing circuitry, a third thermal runaway warning signal when one of the electrical energy storage cell temperatures of an electrical energy storage pack exceeds the temperature threshold, and a second temperature difference between any two electrical energy storage cells of the same electrical energy storage pack exceeds a second temperature difference threshold.

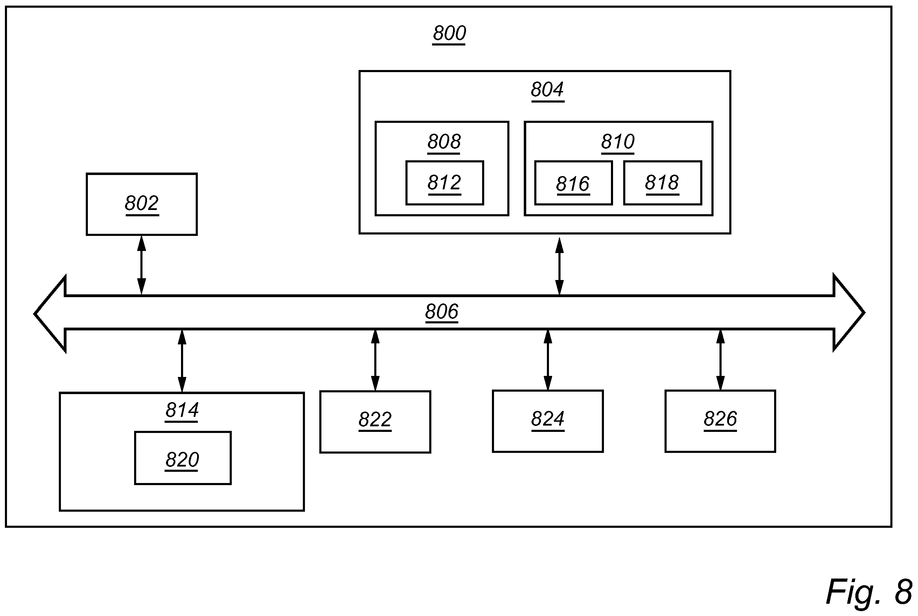

**FIG. 8** is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device
interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: detect an isolation fault in an electrical energy storage system comprising multiple electrical energy storage packs connected in parallel to a voltage bus, the electrical energy storage packs each comprising a set of electrical energy storage cells; disconnect all but one electrical energy storage pack from the voltage bus; determine an isolation resistance for each of the disconnected electrical energy storage packs, determine electrical energy storage cell temperatures for at least two cells in each of the disconnected electrical energy storage packs, provide a first thermal runaway warning signal when the isolation resistance is below a predetermined threshold, and provide a second thermal runaway warning signal when one of the electrical energy storage cell temperatures of an electrical energy storage pack exceeds a temperature threshold, and a temperature difference between any two electrical energy storage cells of the same electrical energy storage pack exceeds a first temperature difference threshold, and provide a third thermal runaway warning signal when one of the electrical energy storage cell temperatures of an electrical energy storage pack exceeds the temperature threshold, and a temperature difference between any two electrical energy storage cells of the same electrical energy storage pack exceeds a second temperature difference threshold.

Example 2: The computer system of example 1, wherein the processing circuitry is further configured to: provide the first thermal runaway warning signal when a measured isolation resistance of a single pole of an electrical energy storage pack is below a single pole resistance threshold or if a measured isolation resistance of two poles of an electrical energy storage pack is below a two-pole resistance threshold.

Example 3: The computer system of example 2, wherein the two-pole resistance threshold is higher than the single pole resistance threshold.

Example 4: The computer system of any of examples 1-3, wherein the processing circuitry is further configured to: provide the second thermal runaway warning signal only when the temperature difference between the two electrical energy storage cells is equal to or exceeds the first temperature difference threshold for a time duration that exceeds or is equal to a predetermined time duration threshold.

Example 5: The computer system of any of examples 1-4, wherein the first temperature difference threshold is lower than he second temperature difference threshold.

Example 6: The computer system of any of examples 1-5, wherein the processing circuitry is further configured to: in response to any of the warning signals, provide an output message to a user interface.

Example 7: The computer system of any of examples 1-6, wherein the processing circuitry is further configured to: determine which one of the electrical energy storage packs has the highest isolation resistance, wherein the one electrical energy storage pack remains connected to the voltage bus.

Example 8: The computer system of example 1, wherein the processing circuitry is further configured to: calculate the first temperature difference based on cell temperature measurements from two cells of each electrical energy storage pack, and receive, over a communication interface, an indication that the second temperature difference exceeds or is equal to the second temperature difference threshold from a pack management unit of the respective electrical energy storage pack.

Example 9: An electric energy storage system comprising the computer system of any of examples 1-8.

Example 10: A vehicle comprising the electrical energy storage system of example 9.

Example 11: A computer-implemented method, comprising: detecting, by processing circuitry of a computer system, an isolation fault in an electrical energy storage system comprising multiple electrical energy storage packs connected in parallel to a voltage bus, the electrical energy storage packs each comprising a set of electrical energy storage cells; disconnecting, by the processing circuitry, all but one electrical energy storage pack from the voltage bus; determining, by the processing circuitry, an isolation resistance for each of the disconnected electrical energy storage packs, determining, by the processing circuitry, electrical energy storage cell temperatures for at least two cells in each of the disconnected electrical energy storage packs, providing, by the processing circuitry, a first thermal runaway warning signal when the isolation resistance is below a predetermined threshold, and providing, by the processing circuitry, a second thermal runaway warning signal when one of the electrical energy storage cell temperatures of an electrical energy storage pack exceeds a temperature threshold, and a temperature difference between any two electrical energy storage cells of the same electrical energy storage pack exceeds a first temperature difference threshold, and providing, by the processing circuitry, a third thermal runaway warning signal when one of the electrical energy storage cell temperatures of an electrical energy storage pack exceeds the temperature threshold, and a temperature difference between any two electrical energy storage cells of the same electrical energy storage pack exceeds a second temperature difference threshold.

Example 12: The method of example 11, comprising: providing by the processing circuitry, the first thermal runaway warning signal when a measured isolation resistance of a single pole of an electrical energy storage pack is below a single pole resistance threshold or if a measured isolation resistance of two poles of an electrical energy storage pack is below a two-pole resistance threshold.

Example 13: The method of example 12, wherein the two-pole resistance threshold is higher than the single pole resistance threshold.

Example 14: The method of any of examples 11-13, comprising: providing, by the processing circuitry, the second thermal runaway warning signal only when the temperature difference between the two electrical energy storage cells is equal to or exceeds the first temperature difference threshold for a time duration that exceeds or is equal to a predetermined time duration threshold.

Example 15: The method of any of examples 11-14, wherein the first temperature difference threshold is lower than the second temperature difference threshold.

Example 16: The method of any of examples 11-15, comprising: in response to any of the warning signals, providing, by the processing circuitry, an output message to a user interface.

Example 17: The method of any of examples 11-16, comprising: determining which one of the electrical energy storage packs has the highest isolation resistance, wherein the one electrical energy storage pack remains connected to the voltage bus.

Example 18: The method of example 11, comprising calculating, by the processing circuitry, the first temperature difference based on cell temperature measurements from two cells of each electrical energy storage pack, and receive, by the processing circuitry over a communication interface, an indication that the second temperature difference exceeds or is equal to the second temperature difference threshold from a pack management unit of the respective electrical energy storage pack.

Example 19: A computer program product comprising program code for performing, when executed by the processing circuitry, the method of any of examples 11-18.

Example 20: A non-transitory computer-readable storage medium comprising instructions, which when executed by the processing circuitry, cause the processing circuitry to perform the method of any of examples 11-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) comprising processing circuitry (102) configured to:
detect an isolation fault in an electrical energy storage system (104) comprising multiple electrical energy storage packs (106) connected in parallel to a voltage bus (108), the electrical energy storage packs each comprising a set of electrical energy storage cells (110);
disconnect all but one electrical energy storage pack (106') from the voltage bus (108);
determine an isolation resistance for each of the disconnected electrical energy storage packs (106),
determine electrical energy storage cell temperatures for at least two cells in each of the disconnected electrical energy storage packs,
provide a first thermal runaway warning signal (W1) when the isolation resistance is below a predetermined threshold, and
provide a second thermal runaway warning signal (W2) when one of the electrical energy storage cell temperatures of an electrical energy storage pack exceeds a temperature threshold, and a first temperature difference between any two electrical energy storage cells of the same electrical energy storage pack exceeds a first temperature difference threshold, and
provide a third thermal runaway warning signal (W3) when one of the electrical energy storage cell temperatures of an electrical energy storage pack exceeds the temperature threshold, and a second temperature difference between any two electrical energy storage cells of the same electrical energy storage pack exceeds a second temperature difference threshold.

2. The computer system of claim 1, wherein the processing circuitry is further configured to:
provide the first thermal runaway warning signal when a measured isolation resistance of a single pole of an electrical energy storage pack is below a single pole resistance threshold or if a measured isolation resistance of two poles of an electrical energy storage pack is below a two-pole resistance threshold.

3. The computer system of claim 2, wherein the two-pole resistance threshold is higher than the single pole resistance threshold.

4. The computer system of any of claims 1-3, wherein the processing circuitry is further configured to:
provide the second thermal runaway warning signal only when the first temperature difference between the two electrical energy storage cells is equal to or exceeds the first temperature difference threshold for a time duration that exceeds or is equal to a predetermined time duration threshold.

5. The computer system of any of claims 1-4, wherein the first temperature difference threshold is lower than the second temperature difference threshold.

6. The computer system of any of claims 1-5, wherein the processing circuitry is further configured to:
in response to any of the warning signals, provide an output message (R) to a user interface (119).

7. The computer system of any of claims 1-6, wherein the processing circuitry is further configured to:
determine which one of the electrical energy storage packs has the highest isolation resistance, wherein the one electrical energy storage pack remains connected to the voltage bus.

8. The computer system of claim 1, wherein the processing circuitry is further configured to:
calculate the first temperature difference based on cell temperature measurements from two cells (110) of each electrical energy storage pack (106), and
receive, over a communication interface (120), an indication that the second temperature difference exceeds or is equal to the second temperature difference threshold from a pack management unit (123) of the respective electrical energy storage pack (106).

9. An electric energy storage system (104) comprising the computer system (100) of any of claims 1-8.

10. A vehicle (150) comprising the electrical energy storage system of claim 9.

11. A computer-implemented method, comprising:
detecting (S102), by processing circuitry of a computer system, an isolation fault in an electrical energy storage system comprising multiple electrical energy storage packs connected in parallel to a voltage bus, the electrical energy storage packs each comprising a set of electrical energy storage cells;
disconnecting (S104), by the processing circuitry, all but one electrical energy storage pack from the voltage bus;
determining (S106), by the processing circuitry, an isolation resistance for each of the disconnected electrical energy storage packs,
determining (S108), by the processing circuitry, electrical energy storage cell temperatures for at least two cells in each of the disconnected electrical energy storage packs,
providing (S110), by the processing circuitry, a first thermal runaway warning signal when the isolation resistance is below a predetermined threshold, and
providing (S112), by the processing circuitry, a second thermal runaway warning signal when one of the electrical energy storage cell temperatures of an electrical energy storage pack exceeds a temperature threshold, and a first temperature difference between any two electrical energy storage cells of the same electrical energy storage pack exceeds a first temperature difference threshold, and
providing (S114), by the processing circuitry, a third thermal runaway warning signal when one of the electrical energy storage cell temperatures of an electrical energy storage pack exceeds the temperature threshold, and a second temperature difference between any two electrical energy storage cells of the same electrical energy storage pack exceeds a second temperature difference threshold.

12. The method of claim 11, comprising:
providing by the processing circuitry, the first thermal runaway warning signal when a measured isolation resistance of a single pole of an electrical energy storage pack is below a single pole resistance threshold or if a measured isolation resistance of two poles of an electrical energy storage pack is below a two-pole resistance threshold.

13. The method of claim 11, comprising:
calculating, by the processing circuitry, the first temperature difference based on cell temperature measurements from two cells (110) of each electrical energy storage pack (106), and
receive, by the processing circuitry over a communication interface (120), an indication that the second temperature difference exceeds or is equal to the second temperature difference threshold from a pack management unit (123) of the respective electrical energy storage pack (106).

14. A computer program product comprising program code for performing, when executed by the processing circuitry, the method of any of claims 11-13.

15. A non-transitory computer-readable storage medium comprising instructions, which when executed by the processing circuitry, cause the processing circuitry to perform the method of any of claims 11-13.
